# Europäisches Patentamt
# European Patent Office
# Office européen des brevets

(11) Publication number: **0 162 522**
**B1**

(12) **EUROPEAN PATENT SPECIFICATION**

(45) Date of publication of patent specification: **24.01.90**

(21) Application number: **85200773.1**

(22) Date of filing: **15.05.85**

(51) Int. Cl.⁵: **G 01 R 31/34**

(54) Apparatus and method for measuring the coil resistance and the connection resistance between the winding and commutator bars in electric motors.

(30) Priority: **24.05.84 IT 2108484**

(43) Date of publication of application:
**27.11.85 Bulletin 85/48**

(45) Publication of the grant of the patent:
**24.01.90 Bulletin 90/04**

(84) Designated Contracting States:
**CH DE FR GB LI NL SE**

(56) References cited:
**DE-C-1 025 070**
**US-A-2 600 088**
**US-A-4 053 830**

(73) Proprietor: **AXIS S.p.A.**
**I-55028 Tavarnelle val di pesa (Florence) (IT)**

(72) Inventor: **Domenichini, Carlo**
**Via Brunelleschi 4**
**I-53036 Poggibonsi, Siena (IT)**
Inventor: **Gastaldin, Gaetano**
**Via V. Ruffo 7**
**I-37131 Verona (IT)**

(74) Representative: **Lotti, Giorgio et al**
**c/o Ing. Barzanò & Zanardo Milano S.p.A. Via Cernaia 20**
**I-10122 Torino (IT)**

Courier Press, Leamington Spa, England.

## Description

This invention relates to a method and an apparatus for measuring the connection resistances and the coil resistances in an electric motor, according to the preambles of claims 1 and 5, respectively.

Control measurements are made on electric motors in order to check the absence of irregularities both in the completed winding and in its connections to the terminals.

A typical case of this general requirement is the checking of wound rotors for commutator machines.

In carrying out this check, the coil resistance has to be evaluated to provide information on the correctness of the winding, its continuity and its insulation, and in addition the correctness of the electrical connection between the winding and the commutator bars also has to be evaluated, whichever known connection system is used for this purpose.

One of the difficulties in making this measurement is the difference in the order of magnitude between the coil resistance and the resistance of a correctly made winding-commutator bar connection.

For this reason, measuring the resistance between those two commutator bars which form the ends of a particular coil is unsatisfactory.

This is because an irregularity in the winding-commutator bar connection does not necessarily produce a connection resistance which is so high as to put such a measurement outside the allowable tolerance limits.

By making a measurement between commutator bars, it is usually not possible to recognise whether an irregularity is due to a defect in the winding or in its connection to the bar.

US—A—4053830 discloses an apparatus and the method for testing armature winding termination "continuity" between windings and commutator bars; this invention however, concerns the method and an apparatus for testing the "resistance" of each commutator bar and of each winding independently from each other.

The method of US—A—4053830, furthermore, is unable to carry out absolute direct measures on coil resistance and connection resistance, it compares voltages across diametrically opposed commutator bars and assumes that the probable unbalance is due to the contact probes connected in series with the resistors.

DE—C—1025070 discloses a method for testing the winding resistance of an armature. This method, however, does not concern the winding-commutator resistance and does not make out the difference between the coil resistance and the connection resistance.

The object of the present invention is to obviate the above drawback by proposing a measuring apparatus and method which enable the operator to measure the contact resistance between the winding and commutator bar independently of the winding resistance measurement, even though using for measurement purposes electrical connections which involve only the commutator bars, ie easily accessible zones.

According to the invention is proposed a method for measuring the connection resistances between the commutator bars and winding and for measuring the coil resistances of said winding in an electric motor with a commutator comprising a plurality of said bars characterized by applying a predetermined voltage between a first and second commutator bar, and a voltage between the first and a third bar such that the voltage measured between two further commutator bars connected to coils not included in that branch of the winding between the second, first and third commutator bar is zero, the voltage between said second bar and one of said further bars and the current flowing between said second and said first bar then being measured, and the resistance of the connection between said second bar and the winding then being determined as the quotient of said measured voltage and current; the method further comprising the rotation clockwise one step with reference to the commutator bars so that the resistance of the connection between the first bar and the winding is calculated; the coil resistance of the winding portion between two adjacent bars being calculated by Ohm's law on the basis of voltage and current measurements made between said two bars and one of said further bars.

The apparatus according to the invention comprising a support for an electric motor rotor having a commutator with a plurality of bars, contact elements arranged to each rest on one of said bars under electrically conducting conditions is characterized by a first voltage generator feeding a predetermined voltage between a first contact element and a second adjacent element, a second voltage generator feeding a predetermined voltage between said first contact element and a third contact element adjacent thereto, means for controlling the voltage of at least one of the generators, means for measuring the current flowing between the second contact element and the first contact element, means for measuring current flowing between the third contact element and the first contact element, means for measuring the voltage between the first and the fourth contact element and the voltage between the fourth contact element and the second contact element; a control circuit being sensitive to the voltage between the fourth and fifth contact element, and which controls the generator voltage regulator means in the sense of nullifying the voltage to which the control circuit is sensitive; said rotor support comprising a means for the rotor in order to rotate it stepwise so as to successively dispose the bars in positions corresponding with said contact elements; the apparatus further comprising a measurement and processing unit for performing the various calculations from the above measured voltages and currents concerning said resistance values.

The object and characteristics of the invention will be more apparent from the description of one embodiment thereof given hereinafter by way of example with reference to the accompanying Figures in which:

Figure 1 is a circuit diagram of the measuring apparatus according to the invention;

Figure 2 is a general view of the apparatus;

Figure 3 shows a detail of the apparatus of Figure 2.

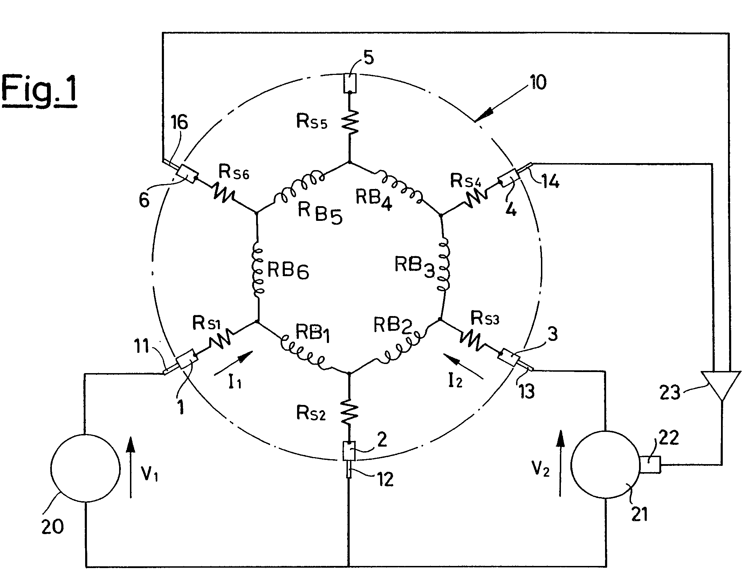

For clarity of description, the measuring system will be considered applied to a rotor in which the winding is connected to six commutator bars, and can be schematised by way of example as shown in Figure 1, in which it is indicated overall by 10.

Each of the commutator bars 1, 2, 3, 4, 5 and 6 is connected to a winding composed of coils $R_{B1}$, $R_{B2}$...$R_{B6}$.

The contact between the bar and winding, of which the resistance is to be evaluated, is indicated diagrammatically as resistances $R_{S1}$, $R_{S2}$...$R_{S6}$.

Contact elements 11, 12, 13, 14 and 16, which can simply be feelers, are applied respectively to the bars 1, 2, 3, 4 and 6. Between the contact elements 11 and 12 there is provided a first voltage generator 20, and a second voltage generator 21 is provided between the elements 12 and 13. The second generator 21 comprises a voltage regulator indicated schematically as the block 22.

The two feelers 14 and 16 are connected to a control circuit 23 which feeds a corresponding signal to the regulator 22 for the purpose indicated hereinafter.

It will be assumed that a voltage $V_1$ is applied between 11 and 12 and an approximately equal voltage $V_2$ between 13 and 12.

The dissymmetry of the arrangement and the difference in the generators causes a difference between the currents $I_1$ and $I_2$.

It will be assumed that the current $I_1$ is greater than $I_2$ and thus prevails over this latter.

$I_1$ breaks down into two parts, the larger of which flows back to the generator 20 through $R_{S1}$—$R_{B1}$—$R_{S2}$. A small part of the current $I_1$ passes through the ring circuit

$$R_{S1}\text{—}R_{B6}\text{—}R_{B5}\text{—}R_{B4}\text{—}R_{B3}\text{—}R_{B2}\text{—}R_{S2}.$$

Under these conditions, there exists between the bars 4 and 6 a voltage sensed by the circuit 23, which controls the regulator 22 in the sense of varying the voltage $V_2$ in such a manner as to nullify the current circulating through $R_{B5}$, $R_{B4}$ and thus also through $R_{B6}$ and $R_{B3}$.

Under such conditions the relationship $R_{S1} = V_{1-6}/I_1$ is immediately obvious, as the current circulating through $R_{B6}$ and $R_{S6}$ is zero.

Thus by simply measuring $V_{1-6}$ between the bars 1 and 6 and knowing $I_1$, ie the current generated by 20, $R_{S1}$ is immediately obtained. The following relationship can also be written:

$$V_{6-2} = R_{B1} \cdot I_1 + R_{S2}(I_1 + I_2)$$

This relationship enables $R_{B1}$ to be found after finding $R_{S2}$. This is done simply by rotating the bars clockwise through one step with respect to the contact elements, so that the bar 2 presents itself to the feeler 11, after which the procedure as heretofore described for obtaining $R_{S1}$ is carried out.

Thus in this manner, by means of successive measurements made by rotating the rotor each time through one step, all the values $R_{B1}$, $R_{B2}$...$R_{B6}$ and $R_{S1}$, $R_{S2}$...$R_{S6}$ are found. For each position it is necessary only to measure two voltages and two currents, ie the currents $I_1$ and $I_2$ and the voltages $V_{6-2}$ and $V_{1-6}$ in the position of Figure 1.

It is obviously possible to generalise the measurement for rotors with any number of bars, and thus with any number of coils, by simply considering the number of bars, and thus the number of coils between the bars on which the feelers 16 and 14 act, as indefinite.

In the particular case described heretofore, the number of bars is one (the bar 5) and the number of coils is two ($R_{B5}$ and $R_{B4}$).

The measurement described heretofore can be made with a particularly simple apparatus, and this constitutes an advantage.

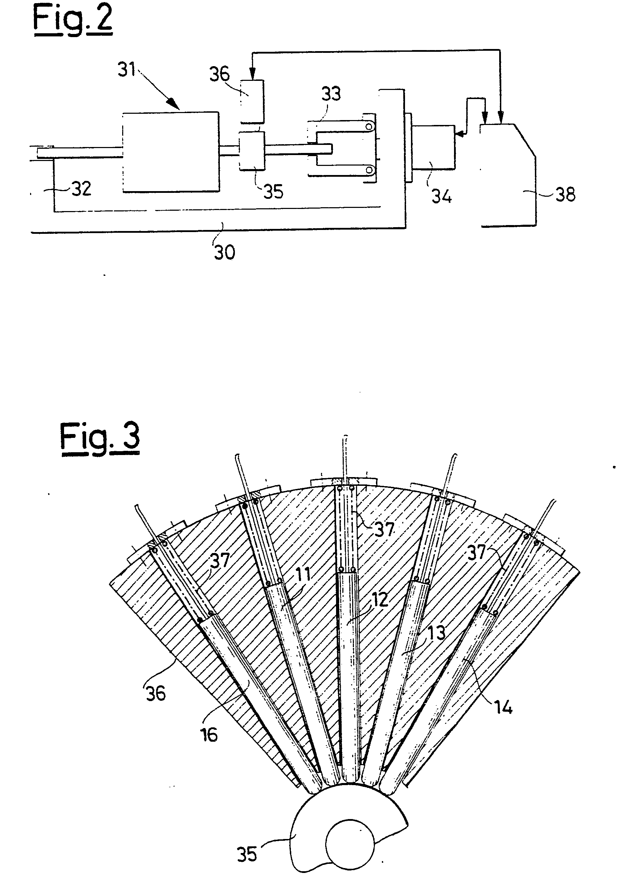

A scheme for such an apparatus is shown in Figure 2. It comprises a bench 30 on which a rotor indicated overall by 31 is freely supported by a support 32 and supported at its other end by a spindle 33 which rotates by the action of a motor 34.

In a position corresponding with the rotor commutator 35 there is mounted a feeler unit 36, in which the feelers are mounted in the manner of a fan so that they each operate on one of the bars of the commutator 35.

This unit can simply be of the type shown in Figure 3, in which feelers are provided in the form of rods slidable in complementary seats under the thrust of springs 37. The constructional characteristics of these parts are not shown in detail because they are within the scope of the expert of the art, and are in any case susceptible to considerable modifications in terms of form and structure. In particular, means can be provided for retracting the feelers when the rotor is moved from its measurement position, in order to prevent damage to the feelers. In addition, two feelers can be provided aligned with each other, ie to operate on the same commutator bar, in those positions in which a current has to be fed to, and a measurement signal withdrawn from, a bar simultaneously. In the present case, this applies to the three central feelers of the five disposed in the fan, these corresponding to the positions of the bars 1, 2 and 3 on the scheme of Figure 1.

The apparatus is also provided with sensors for sensing the angular position of the rotor in order to control its stepwise rotation in such a manner as to move the bars in succession into positions corresponding with the feelers.

A measurement and processing unit 38, which also contains the circuit shown diagrammatically in Figure 1, is associated with the apparatus and connected to the feelers. This unit processes the calculations based on the aforesaid relationships, to memorise, record and display the resistance measurements $R_{s1}$, $R_{s2}$...$R_{sn}$ and $R_{B1}$, $R_{B2}$...$R_{Bn}$, in accordance with the objects of the invention.

From the preceding discussion on the basic principles of the invention and the manner in which it can be implemented, it is possible for the expert of the art to make numerous functionally equivalent modifications to the proposed measurement method and to the relative apparatus, all of which lie within the scope of the inventive idea.

For example, it is apparent that for the purposes of the invention, in measuring the resistances whether these be $R_{Si}$ or $R_{Bi}$, the feelers 11, 12 and 13 must be disposed in such a manner as to contact consecutive commutator bars. The voltage measurement made between the feelers 16 and 14, for the purpose of controlling the voltage regulator of one of the generators, can instead be made between any two further commutator bars other than the bars contacted by the feelers 11, 12 and 13.

Taking account of other possible control measurements which it can be desirable to carry out on the rotor at the inspection stage, the technician can variously choose the position of the feelers in order to rationalise the circuit and the measuring apparatus.

**Claims**

1. A method for measuring the connection resistances ($R_{s1}$...$R_{s6}$) between the commutator bars (1...6) and winding and for measuring the coil resistances ($R_{B1}$...$R_{B6}$) of said winding in an electric motor with a commutator comprising a plurality of said bars (1...6) characterized by applying a predetermined voltage ($V_1$) between a first (2) and second (1) commutator bar, and a voltage ($V_2$) between the first (2) and a third (3) bar such that the voltage measured between two further commutator bars (4, 5, 6) connected to coils not included in that branch of the winding between the second (1), first (2) and third (3) commutator bar is zero, the voltage ($V_{1-6}$) between said second bar (1) and one (6) of said further bars and the current ($I_1$) flowing between said second (1) and said first (2) bar then being measured, and the resistance of the connection ($R_{s1}$) between said second bar (1) and the winding then being determined as the quotient of said measured voltage ($V_{1-6}$) and current ($I_1$); the method further comprising the rotation clockwise one step with reference to the commutator bars (1...6) so that the resistance of the connection ($R_{s2}$) between the first bar (2) and the winding is calculated; the coil resistance ($R_{B1}$) of the winding portion between two adjacent bars (1, 2) being calculated by Ohm's law on the basis of voltage and current measurements made between said two bars (1, 2) and one (6) of said further bars.

2. A method as claimed in claim 1 characterized in that the coil resistance ($R_{B1}$) of the winding portion between two adjacent bars (1, 2) is calculated on the basis of voltage measurements ($V_{6-2}$), made between said first bar (2) and one (6) of said further bars, and current measurements ($I_1$, $I_2$) made on said second (1) and third (3) bars and the calculated resistance of the connection ($R_{s2}$) being calculated by Ohm's law on the basis of voltage and current measurements made between said two bars.

3. A method as claimed in claim 1 characterized in that the steps are sequentially repeated for all the commutators bars (1...6) of the winding whereby each resistance of connection ($R_{s1}$...$R_{s6}$) and each coil resistance ($R_{B1}$...$R_{B6}$) can be determined.

4. A method as claimed in claim 1 characterized in that said winding includes six commutator bars (1...6).

5. An apparatus for carrying out the method of claim 1, comprising a support (32) for an electric motor rotor (31) having a commutator with a plurality of bars (1...6), contact elements (11...16) arranged to each rest on one of said bars (1...6) under electrically conducting conditions, characterized by a first voltage generator (20) feeding a predetermined voltage ($V_1$) between a first contact element (12) and a second adjacent element (11), a second voltage generator (21) feeding a predetermined voltage ($V_2$) between said first contact element (12) and a third contact element (13) adjacent thereto, means (22) for controlling the voltage of at least one (21) of the generators (20, 21), means for measuring the current ($I_1$) flowing between the second contact element (11) and the first contact element (12), means for measuring current ($I_2$) flowing between the third contact element (13) and the first contact element (12), means for measuring the voltage ($V_{6-2}$) between the first (12) and the fourth (16) contact element and the voltage ($V_{6-1}$) between the fourth (16) contact element and the second (11) contact element; a control circuit (23) being sensitive to the voltage between the fourth (16) and fifth (14) contact element, and which controls the generator voltage regulator means (22) in the sense of nullifying the voltage to which the control circuit is sensitive; said rotor support (32) comprising a means (33, 34) for the rotor (31) in order to rotate it stepwise so as to successively dispose the bars (1...6) in positions corresponding with said contact elements (11...16); the apparatus further comprising a measurement and processing unit (38) for performing the various calculations from the above measured voltages and currents concerning said resistance values.

6. An apparatus as claimed in claim 4 characterized in that the means for rotating the rotor (31) is a gripping spindle (33) which rotates by the action of a motor (34).

7. An apparatus as claimed in claim 4 characterized in that the measurement and processing unit (38) provides also means for storing, filing and displaying the data concerning said resistance values.

## Patentansprüche

1. Ein Verfahren zur Messung der Verbindungswiderstände ($R_{s1}...R_{s6}$) zwischen den Kollektorlamellen (1...6) und der Wicklung und zur Messung der Spulenwiderstände ($R_{B1}...R_{B6}$) der Wicklung in einem Elektromotor mit einem eine Mehrzahl von Lamellen (1...6) aufweisenden Kollektor, dadurch gekennzeichnet, daß eine vorbestimmte Spannung ($V_1$) zwischen einer ersten (2) und einer zweiten (1) Kollektorlamelle und eine Spannung ($V_2$) zwischen der ersten (2) und einer dritten (3) Kollektorlamelle in der Weise angelegt wird, daß die zwischen zwei weiteren Kollektorlamellen (4, 5, 6), welche mit Spulen, die nicht in den Zweig der Wicklung zwischen der zweiten (1), ersten (2) und dritten (3) Kollektorlamelle enthalten sind, verbunden sind, gemessene Spannung gleich Null ist, daß die Spannung ($V_{1-6}$) zwischen der zweiten Lamelle (1) und einer (6) der weiteren Lamellen und der zwischen der zweiten (1) und der ersten (2) Lamelle fließende Strom ($I_1$) dann gemessen wird und daß der Widerstand der Verbindung ($R_{s1}$) zwischen der zweiten Lamelle (1) und der Wicklung dann als der Quotient der gemessenen Spannung ($V_{1-6}$) und des Stromes ($I_1$) bestimmt wird, wobei das Verfahren ferner die Rechtsdrehung um einen Schritt bezüglich der Kollektorlamellen (1...6) umfaßt, so daß der Widerstand der Verbindung ($R_{s2}$) zwischen der ersten Lamelle (2) und der Wicklung berechnet wird, und wobei der Spulenwiderstand ($R_{B1}$) des Abschnitts der Wicklung zwischen bei benachbarten Lamellen (1, 2) mittels des Ohmschen Gesetzes auf der Grundlage der zwischen den beiden Lamellen (1, 2) und einer (6) der weiteren Lamellen durchgeführten Spannungs- und Strommessung berechnet wird.

2. Ein Verfahren gemäß Anspruch 1, dadurch gekennzeichnet, daß der Spulenwiderstand ($R_{B1}$) des Abschnittes der Wicklung zwischen zwei benachbarten Lamellen (1, 2) auf der Grundlage von Spannungsmessungen ($V_{6-2}$), welche zwischen der ersten Lamelle (2) und einer (6) der weiteren Lamellen durchgeführt wird, und Strommessungen ($I_1$, $I_2$), welche auf der zweiten (1) und dritten (3) Lamelle durchgeführt werden, berechnet wird und daß der berechnete Widerstand der Verbindung ($R_{s2}$) mittels des Ohmschen Gesetzes auf der Grundlage von Spannungs- und Strommessungen, welche zwischen den beiden Lamellen durchgeführt werden, berechnet wird.

3. Ein Verfahren gemäß Anspruch 1, dadurch gekennzeichnet, daß die Schritte nacheinander für sämtliche Kollektorlamellen (1...6) der Wicklung wiederholt werden, wodurch jeder Widerstand der Verbindung ($R_{s1}...R_{s6}$) und jeder Spulenwiderstand ($R_{B1}...R_{B6}$) bestimmt werden kann.

4. Ein Verfahren gemäß Anspruch 1, dadurch gekennzeichnet, daß die Wicklung sechs Kollektorlamellen (1...6) umfaßt.

5. Eine Vorrichtung zur Durchführung des Verfahrens gemäß Anspruch 1, umfassend einen Träger (32) für einen Elektromotor-Rotor (31) mit einem Kollektor mit einer Mehrzahl von Lamellen (1...6) und Kontaktelementen (11...16), die in der Weise angeordnet sind, daß jedes auf einer der Lamellen (1...6) unter elektrisch leitenden Bedingungen aufliegt, gekennzeichnet durch einen ersten Spannungsgenerator (20), der eine vorbestimmte Spannung ($V_1$) zwischen einem ersten Kontaktelement (12) und einem zweiten benachbarten Element (11) anlegt, einen zweiten Spannungsgenerator (21), der eine vorbestimmte Spannung ($V_2$) zwischen dem ersten Kontaktelement (12) und einem dritten dazu benachbarten Kontaktelement (13) anlegt, Mittel (22) zur Steuerung der Spannung von zumindest einem (21) der Generatoren (20, 21), Mittel zur Messung des zwischen dem zweiten Kontaktelement (11) und dem ersten Kontaktelement (12) fließenden Stromes ($I_1$), Mittel zur Messung des zwischen dem dritten Kontaktelement (13) und dem ersten Kontaktelement (12) fließenden Stromes ($I_2$) und Mittel zur Messung der Spannung ($V_{6-2}$) zwischen dem ersten (12) und dem vierten (16) Kontaktelement und der Spannung ($V_{6-1}$) zwischen dem vierten (16) und dem zweiten (11) Kontaktelement, wobei eine Steuerschaltung (23) auf die Spannung zwischen dem vierten (16) und fünften (14) Kontaktelement anspricht und die Generatorspannung-Reguliermittel (22) in dem Sinne steuert, daß die Spannung, auf welche die Steuerschaltung anspricht, Null wird, und wobei der Rotorträger (32) eine Einrichtung (33, 34) zur schrittweisen Drehung des Rotors (31) umfaßt, um die Lamellen (1...6) nacheinander in zu den den Kontaktelementen (11...16) korrespondierende Stellungen zu bringen, und wobei die Vorrichtung ferner eine Meß- und Recheneinheit (38) zur Durchführung der verschiedenen Berechnungen von den oben gemessenen, die Widerstandswerte betreffenden Spannungen und Strömen umfaßt.

6. Eine Vorrichtung gemäß Anspruch 4, dadurch gekennzeichnet, daß das Mittel zur Drehung des Rotors (31) eine Einspann-Spindel (33) ist, welche durch Betätigung eines Motors (34) rotiert.

7. Eine Vorrichtung gemäß Anspruch 4, dadurch gekennzeichnet, daß die Meß- und Recheneinheit (38) Mittel zur Speicherung, Ablage und Anzeige der die Widerstandswerte betreffenden Daten aufweist.

## Revendications

1. Procédé pour la mesure des résistances ($Rs1...Rs6$) de raccordement entre les lames de collecteur (1...6) et le bobinage et pour la mesure des résistances des enroulements ($R_{B1}...R_{B6}$) dudit bobinage dans un moteur électrique ayant un collecteur comprenant une pluralité de ces lames (1...6), caractérisé par l'application d'une tension prédéterminée ($V_1$) entre une première (2) et une seconde (1) lame du collecteur et d'une tension ($V_2$) entre la première (2) et une troisième (3) lame de façon que la tension mesurée entre deux lames supplémentaires de collecteur (4, 5, 6) reliées aux enroulements non inclus dans cette branche du bobinage entre la seconde (1), la première (2) et la troisième (3) lames du collecteur soit nulle, la tension ($V_{1-6}$) entre cette seconde lame (1) et une (6) de ces lames supplémentaires et le courant ($I_1$) circulant entre cette seconde (1) et cette première (2) lame étant alors mesurée, et la résistance de raccordement (Rs1) entre cette seconde lame (1) et le bobinage étant alors déterminée comme le quotient de cette tension mesurée ($V_{1-6}$) et le courant ($I_1$), cette méthode comprenant en plus la rotation en sens horaire d'un pas par rapport aux lames (1...6) du collecteur de sorte que la résistance du raccordement (Rs2) entre la première lame (2) et le bobinage est calculée; la résistance du bobinage ($R_{B1}$) de la partie de bobinage entre deux lames voisines (1, 2) étant calculée par la loi d'Ohm sur la base des mesures de tension et de courant faites entre ces lames (1), (2) et l'une (6) desdites lames supplémentaires.

2. Procédé selon la revendication 1, caractérisé en ce que la résistance de l'enroulement ($R_{b1}$) de la partie de bobinage entre deux lames voisines (1, 2) est calculée sur la base des mesures de tension ($V_{6-2}$) faites entre ladite première lame (2) et l'une (6) desdites lames supplémentaires et des mesures de courant ($I_1$, $I_2$) faites sur ladite seconde (1) et ladite troisième (3) lame et la résistance calculée de raccordement ($R_{s2}$) étant calculée à l'aide de la loi d'Ohm sur la base des mesures de tension et de courant faites entre lesdites deux lames.

3. Procédé selon la revendication 1, caractérisé en ce que les opérations sont répétées séquentiellement pour toutes les lames (1...6) du collecteur du bobinage de sorte que chaque résistance des raccordements ($R_{s1}...R_{s6}$) et la résistance de chaque enroulement ($R_{B1}...R_{B6}$) peuvent être déterminées.

4. Procédé selon la revendication 1, caractérisé en ce que ledit bobinage comprend six lames de collecteur (1...6).

5. Appareil pour la mise en oeuvre du procédé de la revendication 1, comprenant un support (32) pour un rotor (31) d'un moteur électrique ayant un collecteur avec une pluralité de lames (1...6), d'éléments de contact (11...16) agencés pour reposer chacun sur l'une desdites lames (1...6) dans des conditions de conduction électrique, caractérisé par un premier générateur de tension (20) fournissant une tension prédéterminée ($V_1$) entre un premier élément de contact (12) et un second élément voisin (11), un second générateur de tension (21) fournissant une tension prédéterminée ($V_2$) entre ce premier élément de contact (12) et un troisième élément de contact (13) voisin de ce dernier, un moyen (22) pour contrôler la tension de l'un au moins (21) des générateurs (20, 21), un moyen pour mesurer le courant ($I_1$) circulant entre le second élément de contact (11) et le premier élément de contact (12), un moyen pour mesurer le courant ($I_1$) circulant entre le troisième élément de contact (13) et le premier élément de contact (12), un moyen pour mesurer la tension ($V_{6-2}$) entre le premier (12) et le quatrième (16) élément de contact et la tension ($V_{6-1}$) entre le quatrième (16) élément de contact et le second (11) élément de contact, un circuit de contrôle (23) sensible à la tension entre le quatrième (16) et le cinquième (14) élément de contact et qui contrôle le moyen de régulation de la tension du générateur (22) dans le sens d'annulation de la tension à laquelle le circuit de contrôle est sensible, ce support (32) de rotor comprenant des moyens (33, 34) pour la rotation du rotor (31) pas à pas de manière à disposer successivement les lames (1...6) en position correspondante auxdits éléments de contact (11...16); l'appareil comprenant en outre une unité de mesure et de traitement (38) pour l'exécution des divers calculs relatifs auxdites valeurs des résistances à partir des tensions et des courants mesurés ci-dessus.

6. Appareil selon la revendication 4, caractérisé en ce que les moyens pour la rotation du rotor (31) comprennent un arbre d'entraînement (33) qui tourne par l'action d'un moteur (34).

7. Appareil selon la revendication 4, caractérisé en ce que l'unité de mesure et de traitement (38) comprend aussi des moyens pour mémoriser, classer et afficher les données relatives auxdites valeurs des résistances.

Fig.1

EP 0 162 522 B1

# Fig.2

31
36
33
32
35
34
38
30

# Fig.3

37
37
37
11
12
13
36
16
14
35